# EUROPEAN PATENT SPECIFICATION

(11) **EP 4 339 255 B1**
(45) Date of publication and mention of the grant of the patent: **06.08.2025**
(21) Application number: 23162450.3
(22) Date of filing: 16.03.2023
(51) Int. Cl.: C09J 7/10, C09J 7/30, H10F 19/80

(54) **PHOTOVOLTAIC MODULE**
FOTOVOLTAISCHES MODUL
MODULE PHOTOVOLTAÏQUE

(30) Priority: 16.09.2022 CN 202211129337
(43) Date of publication of application: 20.03.2024
(73) Proprietor: Zhejiang Jinko Solar Co., Ltd., Haining, Zhejiang 314416 (CN); JINKO SOLAR CO., LTD, ShangRao, Jiangxi 334100 (CN)
(72) Inventor: JIN, Hao, ZHEJIANG, 314416 (CN); XIE, Yunfei, 314416, ZHEJIANG (CN); GUO, Zhiqiu, 314416, ZHEJIANG (CN); GAO, Yan, ZHEJIANG, 314416 (CN); FAN, Zixin, ZHEJIANG, 314416 (CN)
(74) Representative: Balder IP Law, S.L.

(56) References cited:
- CN-A- 109 390 423
- CN-A- 112 310 236
- CN-U- 210 640 261
- KR-A- 20070 096 314
- US-A1- 2009 114 261
- US-A1- 2012 048 346
- US-A1- 2019 305 162

## Description

### TECHNICAL FIELD

The disclosure relates in general to the technical field of solar cell modules, and more specifically to an adhesive layer, a method for manufacturing the adhesive layer, and a photovoltaic module.

### BACKGROUND

With the gradual depletion of non-renewable energy such as fossil fuels, photovoltaic power generation, as way for green and renewable energy production, has attracted more and more attention and development.

Photovoltaic power generation involves converting energy from the sun into electricity using photovoltaic modules. One of a few key materials used in the photovoltaic module is an adhesive film. The adhesive film can be used as an internal packaging material of the photovoltaic module, such as crystalline silicon cells, thin film cells, double glass modules, and double-sided cells, and thus plays a key role in the packaging and protection of the photovoltaic module.

The photovoltaic module in related technologies includes a back plate, an adhesive film, solar cells, an adhesive film, and a front plate that are sequentially stacked. Generally, a sum of an area of each of the solar cells is smaller than an area of each adhesive film, and the two layers of adhesive film are separated at the periphery of corresponding solar cells. During laminating, it is easy to cause damage at the periphery of the corresponding solar cells, resulting in edge fragments and thus making the PV module unusable, thereby reducing the yield of the photovoltaic modules.

Therefore, how to provide an adhesive layer, a method for manufacturing the adhesive layer, and a photovoltaic module is a technical problem to be solved.

US patent application US20190305162A1 discloses a solar cell panel. The solar cell panel disclosed therein includes a solar cell; a sealing member including a first sealing member disposed on a first surface of the solar cell and a second sealing member disposed on a second surface of the solar cell; a first cover member disposed on the first sealing member and including a glass substrate; and a second cover member disposed on the second sealing member and including a glass substrate, in which the sealing member includes a central region and an outer region positioned outside the central region, and the outer region includes a reinforcing region having a thickness greater than a thickness of the central region.

Chinese patent application CN210640261U discloses a packaging adhesive film for a photovoltaic module. The packaging adhesive film includes a central area and an edge area which surrounds the central area and is connected with the central area, wherein the thickness of the edge area is greater than that of the central area; the width of the edge area is larger than or equal to the distance from the solder strip at the outermost side of the cell array of the photovoltaic module to the edge of the photovoltaic module, and the thickness of the edge area is 15-20% larger than that of the central area.

Chinese patent application CN112310236A discloses an adhesive packaging film material. The adhesive packaging film material includes a packaging material and a packaging material surrounding the packaging material, wherein the packaging material is fused with the edge of the packaging material.

Korean patent application KR20070096314A discloses a coater for hot melt to form an anti-sliding layer or an adhesive layer on the surface of raw cloth such as a mat without winding the raw cloth to a main roller. A coater for hot melt injects hot melt between a main roller and an auxiliary roller installed at a main body through the nozzle of a supply hose connected with a tank so as to allow the injected hot melt to be coated on the raw cloth on a belt conveyer by the main roller, wherein the main roller is filled with a heat transfer medium and is provided with an electric heater for maintaining the melting temperature of the hot melt to be constant, the rotation velocity of the main roller is larger than the transfer velocity of the belt conveyer for preventing the winding of the raw cloth transferred through the belt conveyer to the main roller, and a continuous transfer part is installed at the main body for the continuous coating of the hot melt.

Chinese patent application CN109390423A discloses a solar cell module in which solar cells are wrapped between two adhesive films comprising encapsulating materials and sealing materials.

US patent application US20120048346A1 discloses a solar cell module comprising: a front substrate; a rear substrate; solar cells disposed between the front substrate and the rear substrate; a barrier layer disposed at least one of between an outer portion of the front substrate and at least one of the solar cells, between the outer portion of the front substrate and the rear substrate, and between the at least one of the solar cells and the rear electrode; and a sealant, at least a part of which is disposed between the rear substrate and the at least one of the solar cells to the inside of the barrier layer in the solar cell module.

US patent application US20090114261A1discloses a photovoltaic module may include a rigid transparent upper layer followed by a pottant layer and a plurality of solar cells. Below the layer of solar cells, there is another pottant layer of similar material to that found in pottant layer. The solar cell may be recessed so that moisture barrier material may be applied along a substantial length of the edge of the module.

### SUMMARY

The invention is as set out in claim 1. The preferred embodiments are set out in the appended set of dependent claims.

### BRIEF DESCRIPTION OF THE DRAWINGS

The accompanying drawings, which are incorporated in and constitute a part of the specification, illustrate embodiments of the disclosure and together with the description thereof, are intended for explaining the principles of the disclosure.
FIG. 1 is a structural schematic view illustrating an adhesive layer according to embodiments of the disclosure.
FIG. 2 is a schematic view illustrating an adhesive layer manufacturing apparatus for manufacturing the adhesive layer according to embodiments of the disclosure.
FIG. 3 is a flow chart illustrating a method for manufacturing an adhesive layer by the adhesive layer manufacturing apparatus according to embodiments of the disclosure.
FIG. 4 is a schematic plan view illustrating a photovoltaic module according to embodiments of the disclosure.
FIG. 5 is a cross-sectional view illustrating the photovoltaic module in a direction A-A' of FIG. 4.

The reference numerals in the figures are illustrated as follows: 1-first portion, 2-second portion, 21-first sub-portion, 22-second sub-portion, 3-base plate, 4-first edge, 5-roller, 6-axis, 7-discharge device, 8-first discharge device, 9-second discharge device, 10-first roller, 11-second roller, 12-third roller, 13-first adhesive layer, 14-second adhesive layer, 15-solar cell, 16-first glass cover plate, 17-second glass cover plate, 100-adhesive layer, 200-photovoltaic module, X-thickness direction, Y-second direction, and Z-third direction.

### DETAILED DESCRIPTION OF THE EMBODIMENTS

Various exemplary embodiments of the disclosure will now be described in detail with reference to the accompanying drawings. It is to be noted that the relative arrangements of components, and the relative order of steps, numeric expressions, and values set forth in these embodiments do not limit the scope of the disclosure unless otherwise specified.

The following description of at least one exemplary embodiment is illustrative only and is not intended to limit the disclosure and application or use of the disclosure.

Techniques, methods, and devices known to those of ordinary skill in the relevant art may not be discussed in detail, but where appropriate, such techniques, methods, and devices should be regarded as part of the specification.

In all examples shown and discussed herein, any specific value should be interpreted as illustrative only and not as a limitation. Therefore, other examples of exemplary embodiments may have different values.

It is to be noted that like numerals and letters denote like terms in the following drawings, and therefore, once an item is defined in one drawing, it does not need to be further discussed in subsequent drawings.

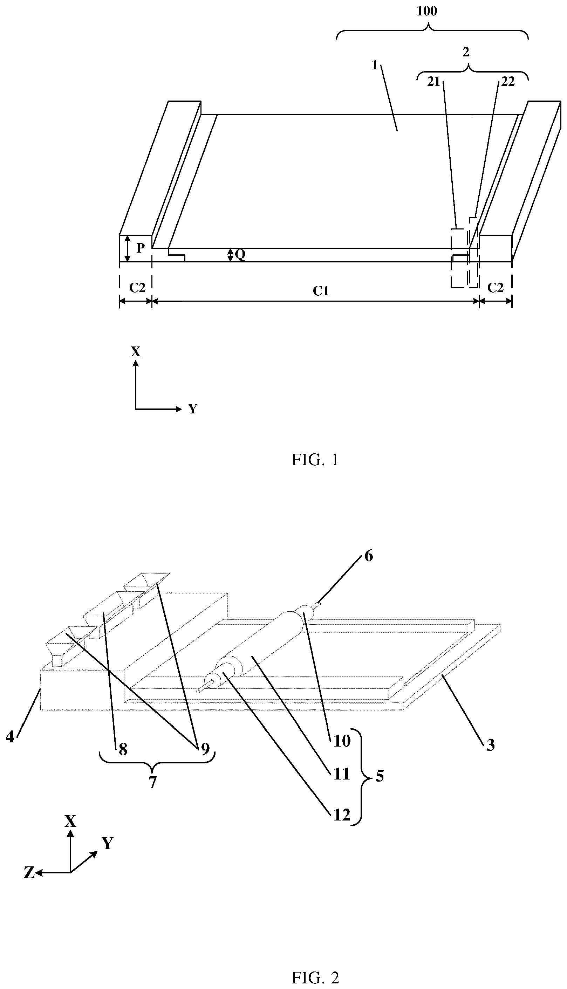

FIG. 1 is a structural schematic view illustrating an adhesive layer according to embodiments of the disclosure, which is a specific embodiment of the adhesive layer 100 provided in the disclosure. As shown in FIG. 1, the adhesive layer 100 has a central region C1 and an edge region C2 at least partially surrounding the central region C1.

The adhesive layer 100 includes a first portion 1 and a plurality of second portions 2. The first portion 1 includes a first material, and each second portion 2 includes a second material. The first portion 1 is located in the central region C1, and each of the plurality of second portions 2 is at least partially located in the edge region C2. In a thickness direction X, the first portion 1 and each of the plurality of second portions 2 are at least partially overlapped. A maximum thickness of each second portion 2 located in the edge region C2 is P, and a maximum thickness of the first portion 1 located in the central region C1 is Q, P > Q.

In FIG. 1, the first portion 1 and each second portion 2 are overlapped in the central region C1, and the plurality of second portions 2 are merely provided on two sides of the first portion 1. It shall be understood that the first portion 1 and each second portion 2 may be overlapped in the edge region C2, and each edge of the first portion 1 is provided with at least one second portion 2, which can be adjusted according to actual needs. In FIG. 1, in an extending direction of each second portion 2, a length of each second portion 2 is equal to a length of the first portion 1. Alternatively, the length of each second portion 2 may be smaller than the length of the first portion 1 in the extending direction of each second portion 2. In addition, each side of two sides of the first portion 1 is provided with at least two second portions 2, and the two second portions 2 are arranged in sequence in the extending direction of each second portion 2. There is a same interval between any two adjacent second portions 2, etc. There is no restriction on the interval between adjacent second portions 2.

It shall be understood that the adhesive layer 100 provided in the disclosure has the central region C1 and the edge region C2 at least partially surrounding the central region C1. The adhesive layer 100 includes a first portion 1 and a plurality of second portions 2. The first portion 1 includes the first material and each second portion 2 includes the second material. The first portion 1 and the second portion 2 are made from different materials, so that the second portion 2 can adopt a material with better water and oxygen isolation effect than the first portion 1, which can further improve the packaging effect of the adhesive film and avoid excessive cost. The first portion 1 is located in the central region C1, and each of the plurality of second portions 2 is at least partially located in the edge region C2. In the thickness direction X, the first portion 1 and each second portion 2 are at least partially overlapped, which can ensure better connection effect between the first portion 1 and each second portion 2 and prevent the second portion 2 from falling off. The maximum thickness of each second portion 2 located in the edge region C2 is P, and the maximum thickness of the first portion 1 located in the central region C1 is Q, P > Q. The second portion 2 can protect the edge of the solar cell and play a supporting role at the edge of the solar cell, so as to avoid the edge damage of the photovoltaic module caused by the gap at the edge of the solar cell during the laminating, and improve the quality and production efficiency of the photovoltaic modules.

In some alternative embodiments, with continued reference to FIG. 1, the first material is an ethylene-vinyl acetate copolymer (EVA) and the second material is a polyethylene octene co-elastomer (POE).

It shall be understood that both the EVA and the POE have the characteristics of high light transmission, ultraviolet resistance, and high temperature resistance. The EVA is the most commonly used film material for photovoltaic modules. The POE is better than EVA in water and oxygen isolation. However, the POE is more expensive than the EVA. Therefore, only the second portions located in the edge region C2 being made from the POE can better prevent water and oxygen from penetrating from the edge of the photovoltaic module, and can also avoid high cost of the adhesive layer 100.

In some alternative embodiments, with continued reference to FIG. 1, 0.38mm ≤ Q ≤ 0.48mm, Q being the maximum thickness of the first portion 1 located in the central region C1.

It shall be understood that in the thickness direction X, the maximum thickness of the first portion 1 located in the central region C1 is Q. If Q < 0.38mm, the adhesion ability of the first portion 1 after lamination is relatively weak. If Q > 0.48mm, the light transmittance of the first portion 1 may be affected and the cost may be increased. Therefore, by setting Q to be in a range of greater than or equal to 0.38mm and less than or equal to 0.48mm (0.38mm ≤ Q ≤ 0.48mm), the adhesion ability of the first portion 1 after lamination is relatively strong and the light transmittance of the first portion 1 is good.

In some alternative embodiments, with continued reference to FIG. 1, each second portion 2 includes a first sub-portion 21 and a second sub-portion 22 that are located in the central region. The first sub-portion 21 is disposed on a side of the second sub-portion 22 adjacent to the first portion 1.

In the thickness direction X, the first sub-portion 21 and the first portion 1 are overlapped.

In a second direction Y, a width of the first sub-portion 21 ranges from 1mm to 20mm.

It shall be understood that the first sub-portion 21 is an overlapping region between the second portion 2 and the first portion 1. In the second direction Y, the longer the width of the first sub-portion 21, the larger the overlapping region between the second portion 2 and the first portion 1, such that the effect of preventing the second portion 2 from falling off the edge of the first portion 1 is good. However, when the width of the first sub-portion 21 is larger than 20mm in the second direction Y, the increase in the width of the first sub-portion 21 cannot further prevent the second portion 2 from falling off from the edge of the first portion 1, and may lead to an increase in cost. Therefore, the width of the first sub-portion 21 being in the range of 1mm to 20mm in the second direction Y is a preferred range, and the first sub-portion 21 may have a width outside the range of 1mm to 20mm. The width of the first sub-portion 21 can be adjusted according to actual situations.

In some alternative embodiments, with continued reference to FIG. 1, taking a cross section in the thickness direction and the cross section extending in the second direction Y, the first sub-portion 21 is rectangular, right-angled trapezoidal, or right-angled triangular in the cross section.

In other words, in a cross section perpendicular to the extending direction of each second portion 2, the first sub-portion 21 is rectangular, right-angled trapezoidal, or right-angled triangular.

In FIG. 1, the first sub-portion 21 is shown to be rectangular in the cross section. The first sub-portion 21 can also be a right-angled trapezoid, a right-angled triangle, or an irregular shape. Alternatively, mutual interpenetration between the first sub-portion 21 and the first portion 1.

In some embodiments, a method for manufacturing an adhesive layer is provided. The adhesive layer is implemented by an adhesive layer manufacturing apparatus, and the adhesive layer manufacturing apparatus includes a base plate, a roller, and a discharge device. The base plate includes a first edge. The roller is disposed on a side of the base plate and includes an axis extending in a second direction. The discharge device, adjacent to the first edge and including a first discharge device and a plurality of second discharge devices, where the plurality of second discharge devices are configured as at least two second discharge devices, where the first discharge device is used for containing a first material and each of the at least two second discharge devices is used for containing a second material. The method includes following operations. The first material and the second material are heated through the first discharge device and the plurality of second discharge devices simultaneously, until the first material and the second material are melted. The roller is rotated about the axis. The first discharge device and the at least t wo second discharge devices discharge simultaneously. The first material is positioned between adjacent second materials, and the first material and the second materials are propagated along a third direction on a surface of the base plate, where the third direction is perpendicular to the second direction. The adhesive layer is formed by extruding the first material and the second materials by the base plate and the roller.

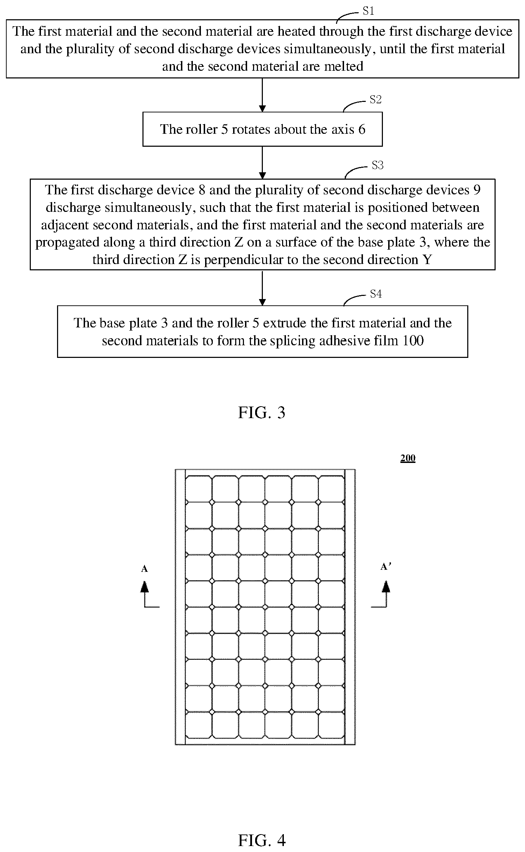

In some alternative embodiments, referring to FIGS. 1, 2, and 3, FIG. 2 is a schematic view illustrating an adhesive layer manufacturing apparatus for manufacturing the adhesive layer, and FIG. 3 is a flow chart illustrating a method for manufacturing an adhesive layer by the adhesive layer manufacturing apparatus, which illustrate a specific embodiment of the method for manufacturing the adhesive layer 100 provided in the disclosure. The adhesive layer 100 provided in the disclosure is manufactured by the adhesive layer manufacturing apparatus, and the adhesive layer manufacturing apparatus includes a base plate 3, a roller 5, and a discharge device 7.

The base plate 3 includes a first edge 4. The roller 5 is disposed on a side of the base plate 3. The roller 5 includes an axis 6 extending in a second direction Y. The discharge device 7 is adjacent to the first edge 4, and includes a first discharge device 8 and a plurality of second discharge devices 9. There are at least two second discharge devices 9. The first discharge device 8 is used for containing the first material and the second discharge device 9 is used for containing the second material.

The method for manufacturing the adhesive layer includes following operations.

At S1, the first material and the second material are heated through the first discharge device and the plurality of second discharge devices simultaneously, until the first material and the second material are melted.

At S2, the roller 5 is rotated about the axis 6.

At S3, the first discharge device 8 and the plurality of second discharge devices 9 discharge simultaneously, such that the first material is positioned between adjacent second materials, and the first material and the second materials are propagated along a third direction Z on a surface of the base plate 3, where the third direction Z is perpendicular to the second direction Y.

At S4, the base plate 3 and the roller 5 extrude the first material and the second materials to form the adhesive layer 100.

It shall be understood that in FIG. 2, only one first discharge device 8 and two second discharge devices 9 are illustrated. In the disclosure, there may be more than one first discharge device 8 and more than two second discharge devices 9. The roller 5 rotates about the axis 6. A height between the roller 5 and the base plate 3 is not changed, which ensures that a thickness of the adhesive layer 100 formed by extrusion of the roller 5 is uniform. The first discharge device 8 and the second discharge devices 9 discharge simultaneously. The first material is located between adjacent second materials. After being extruded by the roller 5 and cooling, the first material forms a first portion 1 and each second material forms a second portion 2. The second portions 2 are located on both sides of the first portion 1. As the roller 5 rotates, the first material and the second material are propagated on the surface of the base plate 3 in a third direction Z, such that the first material and the second materials are transported to the roller 5 for extrusion, to form the adhesive layer 100. During the extrusion of the roller 5 and the base plate 3, the first material and the second material are overlapped at a junction of the first material and the second material. The first material and the second material may also penetrate each other at the junction of the first material and the second material, which helps to increase the adhesion between the first portion 1 and the second portions 2 and prevent the second portions 2 from peeling off from the first portion 1.

In some alternative embodiments, with continued reference to FIGS. 1 and 2, the roller 5 includes a first roller 10, a second roller 11, and a third roller 12 connected in sequence in the second direction Y. The first roller 10 has a diameter of M, the third roller 12 has a diameter of N, and the second roller 11 has a diameter of L, L > M=N.

In the second direction Y, a length of the first roller 10 is L1, a length of the third roller 12 is L3, and a discharge width of the second material is L4, L4 > L1=L3. In the second direction Y, a length of the second roller 11 is L2, and a discharge width of the first material is L5, L5 < L2.

In other words, in the second direction Y, a width of a discharge port of each second discharge device 9 is L4, and a width of a discharge port of the first discharge device 8 is L5.

It shall be understood that the first discharge device 8 corresponds to the second roller 11, and two second discharge devices 9 respectively correspond to the first roller 10 and the third roller 12. The base plate 3 and the roller 5 cooperatively extrude the first material and the second materials to form the adhesive layer 100. A side of the base plate 3 close to the roller 5 is a fixed plane, and a thickness of the adhesive layer 100 depends on a distance between the roller 5 and the base plate 3. The roller 5 has the axis 6. The first roller 10 has the diameter of M, the third roller 12 has the diameter of N, and the diameter of the second roller 11 is L, where L > M=N, such that a distance between the first roller 10 and the base plate 3 is equal to a distance between the third roller 12 and the base plate 3, and is greater than a distance between the second roller 11 and the base plate 3. The first roller 10 and the third roller 12 extrude the second material with the base plate 3 respectively, and the second roller 11 and the base plate 3 extrude the first material, such that the first portion 1 is formed and the plurality of second portions 2 are respectively formed. Therefore, along the thickness direction X, the maximum thickness of each second portion 2 is P, and the maximum thickness of the first portion 1 is Q, P > Q, which can protect the edge of the corresponding solar cells and play a supporting role at the edge of the corresponding solar cells, thus avoiding the edge damage of the photovoltaic module caused by the gap at the edge of the solar cell during the laminating. In the second direction Y, the length of the first roller 10 is L1, the length of the third roller 12 is L3, and the discharge width of the second material is L4, where L4 > L1=L3. In the second direction Y, the length of the second roller 11 is L2, and the discharge width of the first material is L5, where L5 < L2. Since L5 < L2, the second material can be extruded into the central region C1 during the extrusion of the roller 5 and the base plate 3, so that the first material and the second material may be overlapped.

In some alternative embodiments, with continued reference to FIG. 2, the first material in the first discharge device 8 may be heated to 80°C to 90°C, and the second material in the second discharge device 9 may be heated to 95°C to 100°C.

It shall be understood that since the first material and the second material have different melting point temperatures, the melting of the first material and the second material can be ensured by heating the first material filled in the first discharge device to 80°C to 90°C and heating the second material filled in each second discharge device 9 to 95°C to 100°C.

In some alternative embodiments, with continued reference to FIG. 2, a discharge flow rate of the first discharge device 8 is in a range of 3.5 meter per minute (m/min) to 10m/min, and a discharge flow rate of each second discharge device 9 is in a range of 3.5m/min to 10m/min.

It shall be understood that if the first material is EVA, and the second material is POE, since a friction force of the EVA is greater than that of POE, the EVA is more difficult to discharge than POE. Therefore, to ensure smoothness of the adhesive layer 100, a discharge flow rate of the EVA is generally set to be greater than that of the POE. Under the condition that a rotation rate of the roller 5 is determined, if the discharge flow rate of the first material of the first discharge device 8 and the discharge flow rate of the second material of each second discharge device 9 are all less than 3.5m/min, a discharge amount of the first material and the second material may be too little, which may result in uneven or thin adhesive film formed. If the discharge flow rate of the first material of the first discharge device 8 and the discharge flow rate of the second material of each second discharge device 9 are all greater than 10m/min, there may be excessive discharge of the first material and the second material, such that the roller 5 cannot effectively extrude the first material and the second material.

Alternatively, if the first material and the second material include same materials, the friction force of the first material is the same as that of the second material, and in this case, to ensure smoothness of the adhesive layer 100 and the maximum thickness of each second portion to be greater than the maximum thickness of the first portion, the discharge flow rate of the second material may set to be greater than that of the first material.

In some alternative embodiments, with continued reference to FIG. 2, the rotation rate of the roller 5 ranges from 3.5 rotations per minute (RPM) to 10 RPM.

It shall be understood that when the discharge flow rate of the first material of the first discharge device 8 and the discharge flow rate of the second material of the second discharge device 9 are determined to be in the range of 3.5m/min to 10m/min, if the rotation rate of the roller 5 is less than 3.5 RPM, the efficiency of the roller 5 is slow. If the rotation rate of the roller 5 is greater than 10 RPM, the roller 5 cannot effectively extrude the first material and the second material.

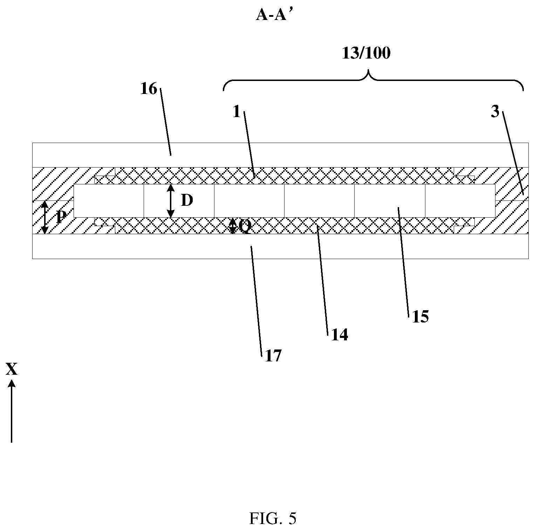

In some alternative embodiments, FIG. 4 is a schematic plan view of a photovoltaic module, and FIG. 5 is a cross-sectional view of the photovoltaic module in direction A-A' of FIG. 4, which are specific embodiments of the photovoltaic module 200 provided in the disclosure. As illustrated in FIGS. 4 and 5, the photovoltaic module 200 includes a glass cover plate including a first glass cover plate 16 and a second glass cover plate 17 that are disposed opposite to each other in a thickness direction X.

At least one adhesive layer 100 is positioned between the first glass cover plate 16 and the second glass cover plate 17. The at least one adhesive layer 100 includes a first adhesive layer 13 and a second adhesive layer 14 opposite to each other.

It shall be understood that each of the at least one adhesive layer 100 is an adhesive layer described in any foregoing embodiment, which are not repeated herein.

At least one solar cell 15 is disposed between the first adhesive layer 13 and the second adhesive layer 14.

FIG. 4 and FIG. 5 only describes the double-glass module as an example of the photovoltaic module 200, including the adhesive layer 100 in the above-mentioned embodiment. It shall be understood that the photovoltaic module 200 provided in the embodiment of the disclosure may also be other photovoltaic modules 200 having the adhesive layer 100, such as a single-glass module. The photovoltaic module 200 provided in the embodiment of the disclosure has the beneficial effect of the adhesive layer 100 provided in embodiments of the disclosure. For details, reference may be made to the specific description of the adhesive layer 100 in the above embodiments, which are not be repeated herein.

In some alternative embodiments, with continued reference to FIGS. 4 and 5, the splice adhesive film 100 includes a first adhesive layer 13 and a second adhesive layer 14 disposed opposite to each other in the thickness direction X. The at least one solar cell 15 is positioned between the first adhesive layer 13 and the second adhesive film 14. The at least one solar cell 15 each have a thickness D along the thickness direction X, where 0.4D ≤ P-Q ≤ 0.6D.

Referring to FIGS. 4 and 5, the first adhesive layer 13 and the second adhesive layer 14 are disposed opposite to each other in the thickness direction X. The at least one solar cell 15 is positioned between the first adhesive layer 13 and the second adhesive layer 14. The first glass cover plate 16 is provided on a side of the first adhesive layer 13 away from the second adhesive layer 14. The second glass cover plate 17 is provided on the side of the second adhesive layer 14 away from the first adhesive layer 13. After the photovoltaic module 200 is laminated, the first adhesive layer 13 and the second adhesive layer 14 wrap the at least one solar cell 15, which can effectively isolate water and oxygen. In addition, FIG. 5 schematically illustrates that the first portion 1 and each second portion 2 are overlapped. In an overlapping region between the first portion 1 and each second portion 2, the second portion 2 is located on a side of the first portion 1 away from the solar cell 15 in the thickness direction X, which can further prevent water and oxygen penetration. In the thickness direction X, the thickness of each solar cell 15 is D, where 0.4D ≤ P-Q ≤ 0.6D. If P-Q is less than 0.4 D (P-Q < 0.4 D), the second portion 2 of the first adhesive film 13 and the second portion 2 of the second adhesive layer 14 has a relatively large spacing, such that the effect of preventing water and oxygen penetration and supporting is poor. If P-Q is greater than 0.6 D (P-Q > 0.6 D), a large stress may be generated on the second portion 2 during the laminating. In some embodiments, P-Q=1/2 D, which can ensure that one side of each of the at least one solar cell 15 is close to the first adhesive layer 13 and the other side of each of the at least one solar cell 15 is close to the second adhesive layer 14 during laminating of the photovoltaic module 200. In addition, there is no gap between the first adhesive layer 13 and the second adhesive layer 14 in the edge region C2, so as to avoid edge damage of the photovoltaic module 200 during the laminating.

As can be seen from the above embodiments, the adhesive layer provided in the disclosure at least realizes the following beneficial effects.

The adhesive layer provided in the disclosure has the central region and the edge region at least partially surrounding the central region. The adhesive layer includes the first portion and the plurality of second portions. The first portion includes the first material. Each of the plurality of second portions includes the second material. The first portion is located in the central region. Each of the plurality of second portions is at least partially located in the edge region. In the thickness direction, the first portion and each second portion are at least partially overlapped. The maximum thickness of each second portion located in the edge region is P, and the maximum thickness of the first portion located in the central region is Q, where P > Q. The first portion and each of the plurality of second portions are made of different materials, so that the second portion can adopt a material with better water and oxygen isolation effect than the first portion, which can further improve the packaging effect of the adhesive film and avoid excessive cost. In the thickness direction, the first portion and the second portion are at least partially overlapped, which can ensure good connection effect between the first portion and the second portions and avoid falling off of the second portions. The maximum thickness of the second portion located in the edge region is P, and the maximum thickness of the first portion located in the central region is Q, where P > Q, such that the second portion can protect the edge of the corresponding solar cells and play a supporting role at the edge position of the corresponding solar cells, so as to avoid the edge damage of the photovoltaic module caused by the gap at the edge position of the corresponding solar cells during the laminating.

## Claims

1. A photovoltaic module (200), comprising:
at least one glass cover plate, comprising a first glass cover plate (16) and a second glass cover plate (17) that are disposed opposite to each other in a thickness direction;
at least one adhesive layer disposed between the first glass cover plate (16) and the second glass cover plate (17) and comprising a first adhesive layer (13) and a second adhesive layer (14) which are opposite to each other; and
a plurality of solar cells (15) disposed between the first adhesive layer (13) and the second adhesive layer (14), wherein each of the at least one adhesive film comprises:
a first portion (1), wherein the first portion (1) includes a first material and is disposed in a central region (C1) of the adhesive film (100); and
a plurality of second portions (2), wherein each of the plurality of second portions (2) includes a second material and is at least partially disposed in an edge region (C2) of the adhesive film (100), the edge region (C2) at least partially surrounding the central region (C1);
wherein the first material and the second material are different materials, the first portion (1) and each of the plurality of second portions (2) are at least partially overlapped in a thickness direction (X), and a maximum thickness P of each of the plurality of second portions (2) disposed in the edge region (C2) is greater than a maximum thickness Q of the first portion (1) disposed in the central region (C1) in the thickness direction (X),
**characterized in that**,
in the thickness direction (X), each of the plurality of solar cells has a thickness of D, wherein 0.4D≤P-Q≤0.6D.

2. The photovoltaic module (200) of claim 1, wherein the first material is an ethylene-vinyl acetate copolymer, EVA, and the second material is a polyethylene octene co-elastomer, POE.

3. The photovoltaic module (200) of claim 1 or 2, wherein the maximum thickness Q of the first portion (1) disposed in the central region (C1) is in a range of greater than or equal to 0.38mm and less than or equal to 0.48mm.

4. The photovoltaic module (200) of any of claims 1 to 3, wherein each of the plurality of second portions (2) includes a first sub-portion (21) and a second sub-portion (22) that are disposed in the central region (C1), wherein
the first sub-portion (21) is disposed on a side of the second sub-portion (22) adjacent to the first portion (1); and
the first sub-portion (1) has a width in a range of 1mm to 20mm in a second direction (Y).

5. The photovoltaic module (200) of claim 4, wherein the first sub-portion (21) is rectangular, right-angled trapezoidal, or right-angled triangular in a cross section perpendicular to an extending direction of each second portion (2).

6. The photovoltaic module (200) of any of claims 1 to 5, wherein the first portion (1) and each of the plurality of second portions (2) are overlapped in the central region (C1), and a length of each of the plurality of second portions (2) is equal to a length of the first portion (1) in an extending direction of each second portion (2).

## Patentansprüche

1. Photovoltaisches Modul (200), umfassend:
mindestens eine Glasabdeckplatte, die eine erste Glasabdeckplatte (16) und eine zweite Glasabdeckplatte (17) umfasst, die einander in einer Dickenrichtung gegenüberliegend angeordnet sind;
mindestens eine Haftschicht, die zwischen der ersten Glasabdeckplatte (16) und der zweiten Glasabdeckplatte (17) angeordnet ist und eine erste Haftschicht (13) und eine zweite Haftschicht (14) umfasst, die einander gegenüberliegen; und
eine Vielzahl von Solarzellen (15), die zwischen der ersten Haftschicht (13) und der zweiten Haftschicht (14) angeordnet sind, wobei jeder von dem mindestens einen Haftfilm umfasst:
einen ersten Abschnitt (1), wobei der erste Abschnitt (1) ein erstes Material umfasst und in einer mittleren Region (C1) des Haftfilms (100) angeordnet ist; und
eine Vielzahl von zweiten Abschnitten (2), wobei jeder der Vielzahl von zweiten Abschnitten (2) ein zweites Material umfasst und zumindest teilweise in einer Randregion (C2) des Haftfilms (100) angeordnet ist, wobei die Randregion (C2) die mittlere Region (C1) zumindest teilweise umgibt;
wobei das erste Material und das zweite Material unterschiedliche Materialien sind, der erste Abschnitt (1) und jeder der Vielzahl von zweiten Abschnitten (2) in einer Dickenrichtung (X) zumindest teilweise überlappt sind und eine Höchstdicke P jedes der Vielzahl von zweiten Abschnitten (2), die in der Randregion (C2) angeordnet sind, größer als eine Höchstdicke Q des ersten Abschnitts (1) ist, der in der mittleren Region (C1) in der Dickenrichtung (X) angeordnet ist,
**dadurch gekennzeichnet, dass**
in der Dickenrichtung (X) jede der Vielzahl von Solarzellen eine Dicke D aufweist, wobei 0,4D≤P-Q≤0,6D.

2. Photovoltaisches Modul (200) nach Anspruch 1, wobei das erste Material ein Ethylenvinylacetat-Copolymer, EVA, ist und das zweite Material ein Polyethylen-Octen-Co-Elastomer, POE, ist.

3. Photovoltaisches Modul (200) nach Anspruch 1 oder 2, wobei die Höchstdicke Q des ersten Abschnitts (1), der in der mittleren Region (C1) angeordnet ist, in einem Bereich von größer oder gleich 0,38 mm und kleiner oder gleich 0,48 mm liegt.

4. Photovoltaisches Modul (200) nach einem der Ansprüche 1 bis 3, wobei jeder der Vielzahl von zweiten Abschnitten (2) einen ersten Unterabschnitt (21) und einen zweiten Unterabschnitt (22) umfasst, die in der mittleren Region (C1) angeordnet sind, wobei
der erste Unterabschnitt (21) auf einer Seite des zweiten Unterabschnitts (22) benachbart zum ersten Abschnitt (1) angeordnet ist; und
der erste Unterabschnitt (1) eine Breite in einem Bereich von 1 mm bis 20 mm in einer zweiten Richtung (Y) aufweist.

5. Photovoltaisches Modul (200) nach Anspruch 4, wobei der erste Unterabschnitt (21) in einem Querschnitt senkrecht zu einer Erstreckungsrichtung jedes zweiten Abschnitts (2) rechteckig, rechtwinklig trapezförmig oder rechtwinklig dreieckig ist.

6. Photovoltaisches Modul (200) nach einem der Ansprüche 1 bis 5, wobei der erste Abschnitt (1) und jeder der Vielzahl von zweiten Abschnitten (2) in der mittleren Region (C1) überlappt sind und eine Länge jedes der Vielzahl von zweiten Abschnitten (2) gleich einer Länge des ersten Abschnitts (1) in einer Erstreckungsrichtung jedes zweiten Abschnitts (2) ist.

## Revendications

1. Module photovoltaïque (200) comprenant :
au moins une plaque de recouvrement en verre, comprenant une première plaque de recouvrement en verre (16) et une deuxième plaque de recouvrement en verre (17) qui sont disposées opposées l'une à l'autre dans la direction de l'épaisseur ;
au moins une couche adhésive disposée entre la première plaque de recouvrement en verre (16) et la deuxième plaque de recouvrement en verre (17) et comprenant une première couche adhésive (13) et une deuxième couche adhésive (14) qui sont opposées l'une à l'autre ; et
une pluralité de cellules solaires (15) disposées entre la première couche adhésive (13) et la deuxième couche adhésive (14),
dans lequel chacun parmi l'au moins un film adhésif comprend :
une première portion (1), laquelle première portion (1) contient un premier matériau et est disposée dans une région centrale (C1) du film adhésif (100) ; et
une pluralité de deuxièmes portions (2), dans laquelle chacune parmi la pluralité de deuxièmes portions (2) contient un deuxième matériau et est au moins partiellement disposée dans une région de bord (C2) du film adhésif (100), la région de bord (C2) entourant au moins partiellement la région centrale (C1) ;
dans lequel le premier matériau et le deuxième matériau sont des matériaux différents, la première portion (1) et chacune parmi la pluralité de deuxièmes portions (2) sont en chevauchement au moins partiel dans la direction de l'épaisseur (X), et l'épaisseur maximale P de chacune parmi la pluralité de deuxièmes portions (2) disposée dans la région de bord (C2) est supérieure à l'épaisseur maximale Q de la première portion (1) disposée dans la région centrale (C1) dans la direction de l'épaisseur (X),
**caractérisé en ce que**
dans la direction de l'épaisseur (X), chacune parmi la pluralité de cellules solaires a une épaisseur D, et dans lequel 0,4D < P-Q < 0,6D.

2. Module photovoltaïque (200) selon la revendication 1, dans lequel le premier matériau est un copolymère d'éthylène-acétate de vinyle, EVA, et le deuxième matériau est un co-élastomère de polyéthylène-octène, POE.

3. Module photovoltaïque (200) selon la revendication 1 ou 2, dans lequel l'épaisseur maximale Q de la première portion (1) disposée dans la région centrale (C1) est située dans la plage allant de 0,38 mm ou plus à 0,48 mm ou moins.

4. Module photovoltaïque (200) selon l'une quelconque des revendications 1 à 3, dans lequel chacune parmi la pluralité de deuxièmes portions (2) comprend une première sous-portion (21) et une deuxième sous-portion (22) qui sont disposées dans la région centrale (C1), et dans lequel
la première sous-portion (21) est disposée sur un côté de la deuxième sous-portion (22) adjacente à la première portion (1) ; et
la première sous-portion (1) a une largeur située dans la plage allant de 1 mm à 20 mm dans une deuxième direction (Y).

5. Module photovoltaïque (200) selon la revendication 4, dans lequel la première sous-portion (21) est rectangulaire, trapézoïdale à angle droit, ou triangulaire à angle droit dans une section transversale perpendiculaire à la direction d'extension de chaque deuxième portion (2).

6. Module photovoltaïque (200) selon l'une quelconque des revendications 1 à 5, dans lequel la première portion (1) et chacune parmi la pluralité de deuxièmes portions (2) sont en chevauchement dans la région centrale (C1), et la longueur de chacune parmi la pluralité de deuxièmes portions (2) est égale à la longueur de la première portion (1) dans la direction d'extension de chaque deuxième portion (2).
